# EUROPEAN PATENT APPLICATION

(11) **EP 4 769 405 A1**
(43) Date of publication of application: **01.07.2026**
(21) Application number: 25224061.9
(22) Date of filing: 16.12.2025
(51) Int. Cl.: G11C 8/12, G11C 16/30

(54) **NONVOLATILE MEMORY DEVICE FOR MINIMIZING COMMON SOURCE LINE BOUNCING AND OPERATING METHOD THEREOF**

(30) Priority: 27.12.2024 KR 20240198664
(71) Applicant: SK hynix Inc., Bubal-eub Icheon-si Gyeonggi-do 17336 (KR)
(72) Inventor: KO, Gwi Han, 17336 Icheon-si, Gyeonggi-do (KR); KIM, Jong Woo, 17336 Icheon-si, Gyeonggi-do (KR); PARK, Tae Hun, 17336 Icheon-si, Gyeonggi-do (KR); CHAI, Soo Yeol, 17336 Icheon-si, Gyeonggi-do (KR)
(74) Representative: Isarpatent

(57) **Abstract**

A nonvolatile memory device includes N planes each comprising a plurality of memory blocks, N discharge control circuits adjacent to the N planes, respectively, and configured to connect each common source line of the N planes and a ground voltage terminal in response to each one of N discharge control signals, a plane selection circuit configured to select K planes of the N planes, and an operation control circuit configured to adjust voltage levels of K discharge control signals according to a distance difference between the ground voltage terminal and each of K discharge control circuits corresponding to the K planes, among the N discharge control circuits.

## Description

### BACKGROUND

### 1. Field

Various embodiments of the present disclosure relate to a semiconductor technology, and specifically, to a nonvolatile memory device for minimizing common source line bouncing and an operating method thereof.

### 2. Discussion of the Related Art

Memory systems are storage devices embodied using a semiconductor such as silicon (Si), germanium (Ge), gallium arsenide (GaAs), indium phosphide (InP), or the like. The memory systems are classified into a volatile memory device and a nonvolatile memory device. The volatile memory device is a memory device in which data stored therein is lost when power supply is interrupted. Representative examples of the volatile memory device include static Random Access Memory (SRAM), dynamic RAM (DRAM), synchronous DRAM (SDRAM), etc. The nonvolatile memory device is a memory device in which data stored therein is retained even when power supply is interrupted. Representative examples of the nonvolatile memory device include a read only memory (ROM), a programmable ROM (PROM), an electrically programmable ROM (EPROM), an electrically erasable programmable ROM (EEPROM), a flash memory, a phase-change random access memory (PRAM), a magnetic RAM (MRAM), a resistive RAM (RRAM), a ferroelectric RAM (FRAM), etc. Flash memories are chiefly classified into a NOR-type memory and NAND-type memory.

In a nonvolatile memory device, a source line bouncing phenomenon occurs when the potential of a source plate undesirably rises during a program operation, a read operation or a verify operation. Since the source line bouncing phenomenon causes an under programming, a read failure or the like, it is necessary to suppress the source line bouncing phenomenon.

### SUMMARY

Various embodiments of the present disclosure are directed to providing a nonvolatile memory device capable of minimizing common source line bouncing and an operating method thereof.

Technical problems to be solved by the present disclosure are not limited to the aforementioned technical problems and the other unmentioned technical problems will be clearly understood by those skilled in the art from the following description.

In an embodiment of the present disclosure a nonvolatile memory device may include: N planes each comprising a plurality of memory blocks; N discharge control circuits adjacent to the N planes, respectively, and configured to connect each common source line of the N planes and a ground voltage terminal in response to each one of N discharge control signals; a plane selection circuit configured to select K planes of the N planes; and an operation control circuit configured to adjust voltage levels of K discharge control signals according to a distance difference between the ground voltage terminal and each of K discharge control circuits corresponding to the K planes, among the N discharge control circuits, wherein N may be a natural number greater than or equal to 2, and K may be a natural number less than or equal to N and greater than or equal to 1.

In an embodiment of the disclosure, an operating method of a nonvolatile memory device comprising N planes each comprising a plurality of nonvolatile memory cells and N discharge control circuits for connecting each common source line of the N planes and a ground voltage terminal in response to each one of N discharge control signals, the operating method may include: selecting K planes of the N planes; and adjusting voltage levels of K discharge control signals according to a distance difference between the ground voltage terminal and each one of K discharge control circuits corresponding to the K planes, wherein N may be a natural number greater than or equal to 2, and K may be a natural number less than or equal to N and greater than or equal to 1.

In an embodiment of the disclosure, a memory device may include: a plurality of planes, each plane including a plurality of memory cells coupled to a common source line; a plurality of discharge control circuits coupled to the plurality of planes, respectively; and a control circuit coupled to the plurality of planes, and including; a plane selection circuit configured to generate selection signals for selecting multiple planes for a verification and read operation, among the plurality of planes; and an operation control circuit configured to generate multiple discharge control signals to be provided to the multiple planes, based on a distance between the ground voltage terminal and each of multiple discharge control circuits corresponding to the multiple planes, among the plurality of discharge control circuits, wherein the multiple planes may connect the common source lines and a ground voltage terminal based on voltage levels of the multiple discharge control signals, respectively.

The embodiments of the present disclosure can adjust a voltage level of a signal for controlling a connection between a common source line of each of a plurality of planes and a ground voltage terminal according to a physical position difference between the common source line of each of the plurality of planes and the ground voltage terminal.

Consequently, the occurrence of common source line bouncing can be minimized.

### BRIEF DESCRIPTION OF THE DRAWINGS

FIG. 1 is a diagram for describing the configuration of a nonvolatile memory device in accordance with an embodiment of the present disclosure.
FIGS. 2A and 2B are diagrams for describing the physical arrangement of a plurality of discharge control circuits included in the nonvolatile memory device in accordance with an embodiment of the present disclosure.
FIG. 3 is a diagram for describing the configuration of each of a plurality of planes included in the nonvolatile memory device in accordance with an embodiment of the present disclosure.
FIG. 4 is a diagram for describing the structure of each of a plurality of memory blocks included in the nonvolatile memory device in accordance with an embodiment of the present disclosure.
FIG. 5A is a circuit diagram for describing a discharge control circuit of a first group included in the nonvolatile memory device in accordance with an embodiment of the present disclosure.
FIG. 5B is a circuit diagram for describing a discharge control circuit of a second group included in the nonvolatile memory device in accordance with an embodiment of the present disclosure.

### DETAILED DESCRIPTION

Various embodiments of the present disclosure are described below with reference to the accompanying drawings. Elements and features of the disclosure, however, may be configured or arranged differently to form other embodiments, which may be variations of any of the disclosed embodiments.

In this disclosure, references to various features (e.g., elements, structures, modules, components, steps, operations, characteristics, etc.) included in "one embodiment," "example embodiment," "an embodiment," "another embodiment," "some embodiments," "various embodiments," "other embodiments," "alternative embodiment," and the like are intended to mean that any such features are included in one or more embodiments of the present disclosure, but may or may not necessarily be combined in the same embodiments.

In this disclosure, the terms "comprise," "comprising," "include," and "including" are open-ended. As used in the appended claims, these terms specify the presence of the stated elements and do not preclude the presence or addition of one or more other elements. The terms in a claim do not foreclose the apparatus from including additional components (e.g., an interface unit, circuitry, etc.).

In this disclosure, various units, circuits, or other components may be described or claimed as "configured to" perform a task or tasks. In such contexts, "configured to" is used to connote structure by indicating that the blocks/units/circuits/components include structure (e.g., circuitry) that performs one or more tasks during operation. As such, the block/unit/circuit/component can be said to be configured to perform the task even when the specified block/unit/circuit/component is not currently operational (e.g., is not turned on nor activated). The block/unit/circuit/component used with the "configured to" language includes hardware-for example, circuits, memory storing program instructions executable to implement the operation, etc. Additionally, "configured to" can include a generic structure (e.g., generic circuitry) that is manipulated by software and/or firmware (e.g., an FPGA or a general-purpose processor executing software) to operate in a manner that is capable of performing the task(s) at issue. "Configured to" may also include adapting a manufacturing process (e.g., a semiconductor fabrication facility) to fabricate devices (e.g., integrated circuits) that implement or perform one or more tasks.

As used in this disclosure, the term 'circuitry' or 'logic' refers to all of the following: (a) hardware-only circuit implementations (such as implementations in only analog and/or digital circuitry) and (b) combinations of circuits and software (and/or firmware), such as (as applicable): (i) to a combination of processor(s) or (ii) to portions of processor(s)/software (including digital signal processor(s)), software, and memory(ies) that work together to cause an apparatus, such as a mobile phone or server, to perform various functions and (c) circuits, such as a microprocessor(s) or a portion of a microprocessor(s), that require software or firmware for operation, even if the software or firmware is not physically present. This definition of 'circuitry' or 'logic' applies to all uses of this term in this application, including in any claims. As a further example, as used in this application, the term "circuitry" or "logic" also covers an implementation of merely a processor (or multiple processors) or a portion of a processor and its (or their) accompanying software and/or firmware. The term "circuitry" or "logic" also covers, for example, and if applicable to a particular claim element, an integrated circuit for a storage device.

As used herein, the terms "first," "second," "third," and so on are used as labels for nouns that the terms precede, and do not imply any type of ordering (e.g., spatial, temporal, logical, etc.). The terms "first" and "second" do not necessarily imply that the first value must be written before the second value. Further, although the terms may be used herein to identify various elements, these elements are not limited by these terms. These terms are used to distinguish one element from another element that otherwise have the same or similar names. For example, a first circuitry may be distinguished from a second circuitry.

Further, the term "based on" is used to describe one or more factors that affect a determination. This term does not foreclose additional factors that may affect a determination. That is, a determination may be solely based on those factors or based, at least in part, on those factors. For example, the phrase "determine A based on B." While in this case, B is a factor that affects the determination of A, such a phrase does not foreclose the determination of A from also being based on C. In other instances, A may be determined based solely on B.

Herein, an item of data, a data item, a data entry or an entry of data may be a sequence of bits. For example, the data item may include the contents of a file, a portion of the file, a page in memory, an object in an object-oriented program, a digital message, a digital scanned image, a part of a video or audio signal, metadata or any other entity which can be represented by a sequence of bits. According to an embodiment, the data item may include a discrete object. According to another embodiment, the data item may include a unit of information within a transmission packet between two different components.

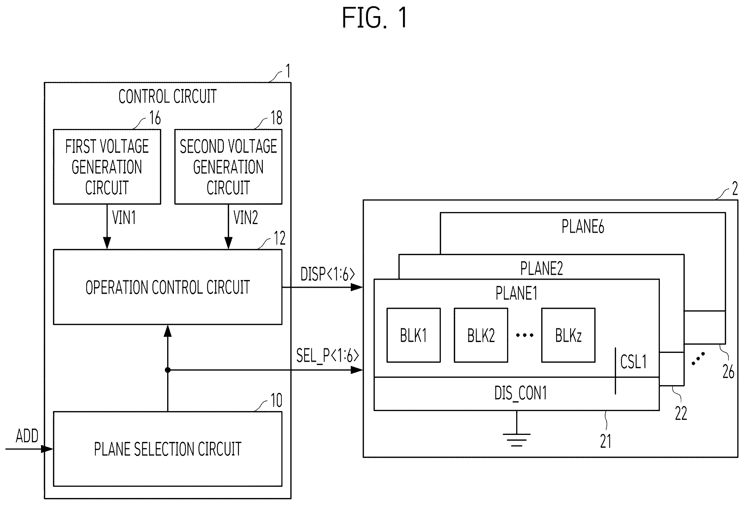

FIG. 1 is a diagram for describing the configuration of a nonvolatile memory device in accordance with an embodiment of the present disclosure.

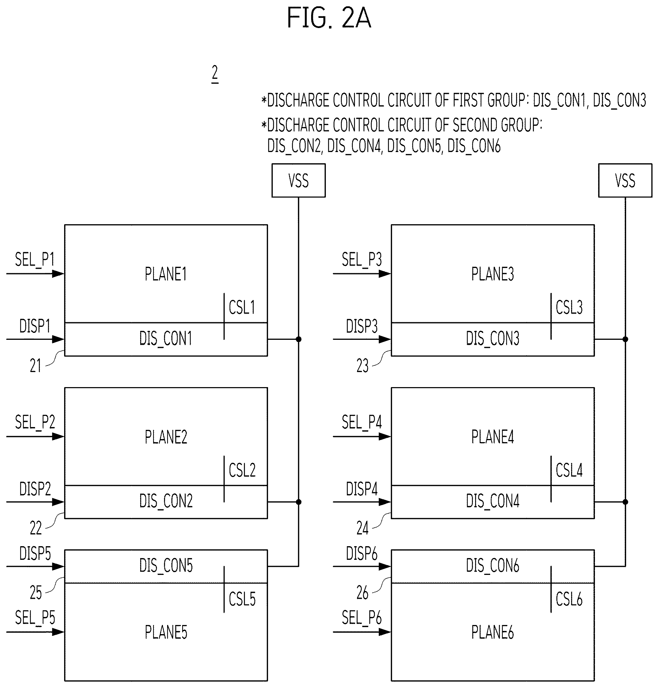

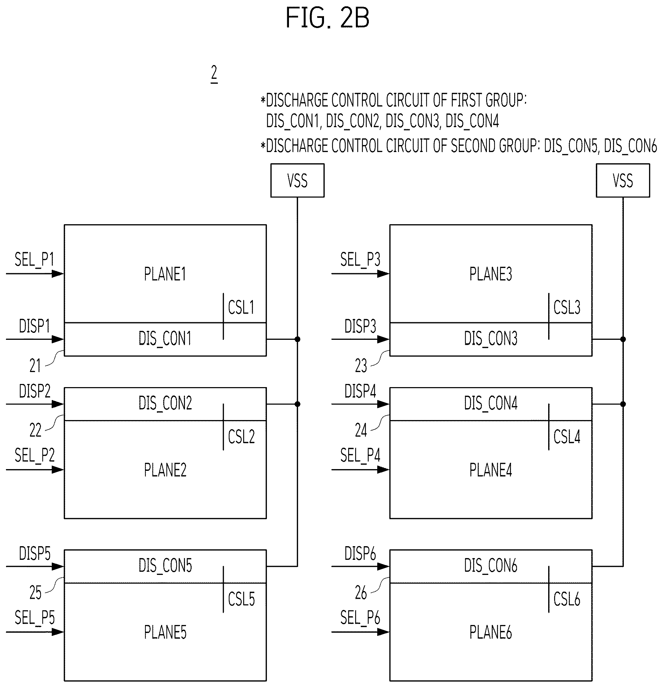

FIGS. 2A and 2B are diagrams for describing the physical arrangement of a plurality of discharge control circuits included in the nonvolatile memory device in accordance with the embodiment of the present disclosure.

Referring to FIG. 1, the nonvolatile memory device includes a control circuit 1 and a memory cell array 2.

The memory cell array 2 includes a plurality of planes PLANE<1:6> and a plurality of discharge control circuits (DIS_CON) 21 to 26.

Specifically, each of the plurality of planes PLANE<1:6> includes a plurality of memory blocks BLK1-BLKz, where z is a natural number greater than or equal to 2. Each of the plurality of memory blocks BLK1-BLKz includes a plurality of pages.

The memory blocks may be understood as a group of non-volatile memory cells from which data are removed together through an erase operation. Each of the memory blocks may include a page in which the non-volatile memory cells are grouped, from a logical point of view, such as storing data together during the program operation or outputting data together during the read operation. For example, one memory block may include a plurality of pages. One page may include a plurality of non-volatile memory cells.

From a physical point of view different from the logical point of view such as the program operation or the read operation, one memory block may include a plurality of word lines (not illustrated). One word line may include a plurality of non-volatile memory cells.

In one embodiment, one word line may correspond to at least one page according to the number of bits that can be stored or expressed in one non-volatile memory cell. For example, when one non-volatile memory cell is a single level cell (SLC) storing one data bit, one word line may correspond to one page. When one non-volatile memory cell is a double level cell (DLC) storing two data bits, one word line may correspond to two pages. When one non-volatile memory cell is a triple level cell (TLC) storing three data bits, one word line may correspond to three pages. When one non-volatile memory cell is a quadruple level cell (QLC) storing four data bits, one word line may correspond to four pages. In this way, when one non-volatile memory cell is a multiple level cell storing five or more data bits, one word line may correspond to five or more pages.

Each of the plurality of discharge control circuits 21 to 26 is physically adjacent to a corresponding plane of the plurality of planes PLANE<1:6>. Each of the plurality of discharge control circuits 21 to 26 connects a corresponding common source line of the common source lines CSL<1:6> of the plurality of planes PLANE<1:6> and a ground voltage (VSS) terminal in response to each of the plurality of discharge control signals DISP<1:6>.

According to an embodiment, a first discharge control circuit (DIS_CON1) 21 controls a connection between the common source line CSL1 of a first plane PLANE1 and the ground voltage (VSS) terminal in response to a first discharge control signal DISP1. A second discharge control circuit (DIS_CON2) 22 controls a connection between the common source line CSL2 of a second plane PLANE2 and the ground voltage (VSS) terminal in response to a second discharge control signal DISP2. A third discharge control circuit (DIS_CON3) 23 controls a connection between the common source line CSL3 of a third plane PLANE3 and the ground voltage (VSS) terminal in response to a third discharge control signal DISP3. A fourth discharge control circuit (DIS_CON4) 24 controls a connection between the common source line CSL4 of a fourth plane PLANE4 and the ground voltage (VSS) terminal in response to a fourth discharge control signal DISP4. A fifth discharge control circuit (DIS_CON5) 25 controls a connection between the common source line CSL5 of a fifth plane PLANE5 and the ground voltage (VSS) terminal in response to a fifth discharge control signal DISP5. A sixth discharge control circuit (DIS_CON6) 26 controls a connection between the common source line CSL6 of a sixth plane PLANE6 and the ground voltage (VSS) terminal in response to a sixth discharge control signal DISP6.

In this way, the number of the plurality of discharge control circuits 21 to 26 is the same as the number of the plurality of planes PLANE<1:6> and corresponds to one another in a one-to-one manner. That is, when the number of the plurality of planes PLANE<1:6> is N, where N is a natural number greater than or equal to 2, the number of the plurality of discharge control circuits 21 to 26 is also N.

The drawing illustrates that N is 6, but this is merely one embodiment and N can be set to any other value. The following description is given based on that N is 6, that is, that the memory cell array 2 includes 6 planes PLANE<1:6>.

The control circuit 1 is configured to perform a program operation, a read operation, or an erase operation on a selected area of the memory cell array 2.

The program operation includes a program pulse application operation and a verification operation.

First, the program pulse application operation is an operation of applying a program pulse, whose voltage is gradually increased, to a program word line, to which memory cells selected to be programmed are connected, according to an incremental step pulse program (ISPP) algorithm and changing a threshold voltage of the memory cells selected to be programmed.

The verification operation is an operation of checking whether the threshold voltage level of the memory cells selected to be programmed has reached a target voltage level through an operation of applying a verification pulse set to the target voltage level to the program word line after applying the program pulse through the program operation.

Accordingly, in the program operation, the program pulse application operation and the verification operation are alternately performed according to the ISPP algorithm.

The read operation is an operation of checking a data value stored in memory cells selected to be read based on the target voltage level through an operation of applying a read pulse set to the target voltage level to a read word line to which the memory cells selected to be read are connected.

The verification operation and the read operation are almost the same in operation method and condition in that they are operations of checking the threshold voltage level status of the selected memory cells. Therefore, a source line bouncing phenomenon occurs in the verification operation and the read operation due to almost the same reason. Accordingly, in the present disclosure, the 'verification operation' and the 'read operation' are grouped into one operation and referred to as a 'verification/read operation'.

The control circuit 1 includes a plane selection circuit 10, an operation control circuit 12, a first voltage generation circuit 16, and a second voltage generation circuit 18.

The plane selection circuit 10 sets values of a plurality of plane selection signals SEL_P<1:6> to select at least one of the plurality of planes PLANE<1:6> in response to an address ADD applied from the outside.

According to an embodiment, the plane selection circuit 10 sets the values of the plurality of plane selection signals SEL_P<1:6> to select at least one of the plurality of planes PLANE<1:6> as a verification/read operation target.

According to another embodiment, the plane selection circuit 10 sets the values of the plurality of plane selection signals SEL_P<1:6> to select at least one of the plurality of planes PLANE<1:6> as a program pulse application operation target.

According to further another embodiment, the plane selection circuit 10 sets the values of the plurality of plane selection signals SEL_P<1:6> to select at least one of the plurality of planes PLANE<1:6> to be in an idle state in which no operation is performed.

For example, the plane selection circuit 10 selects the first plane PLANE1 and the second plane PLANE2 among the six planes PLANE<1:6> included in the memory cell array 2 as read operation targets, and selects the fifth plane PLANE5 as a verification operation target. That is, in response to the address ADD, the plane selection circuit 10 sets a first plane selection signal SEL_P1 and a second plane selection signal SEL_P2 as values for selecting the read operation target, and sets a fifth plane selection signal SEL_P5 as a value for selecting the verification operation target.

The selection of the fifth plane PLANE5 as the verification operation target means that the fifth plane PLANE5 is repeatedly selected as the program pulse application operation target and the verification operation target according to the ISPP algorithm. In such a case, in the state in which the first plane PLANE1 and the second plane PLANE2 among the six planes PLANE<1:6> are selected as the read operation targets, the plane selection circuit 10 repeatedly selects the fifth plane PLANE5 as the verification operation target and the program pulse application operation target. That is, when the first plane selection signal SEL_P1 and the second plane selection signal SEL_P2 were set as the values for selecting the read operation target in response to the address ADD, the plane selection circuit 10 repeatedly sets the fifth plane selection signal SEL_P5 as the value for selecting the program pulse application operation target and the value for selecting the verification operation target.

After the plane selection circuit 10 selects at least one plane for the verification/read operation, the program pulse application operation, or in the idle state, and the operation control circuit 12 adjusts the voltage level of the discharge control signals DISP<1:6> according to the physical position between each of the discharge control circuits 21 to 26 corresponding to the selected plane and the ground voltage (VSS) terminal.

For example, the plane selection circuit 10 selects the first plane PLANE1 among the six planes PLANE<1:6> included in the memory cell array 2 as the read operation target, and selects the fifth plane PLANE5 as the verification operation target. In such a case, the operation control circuit 12 checks the physical position between the DIS_CON1 21 corresponding to the first plane PLANE1 and the ground voltage (VSS) terminal, and the physical position of the DIS_CON5 25 corresponding to the fifth plane PLANE5, and adjusts the level of the first discharge control signal DISP1 applied to the DIS_CON1 21 and the level of the fifth discharge control signal DISP5 applied to the DIS_CON5 25, according to the check result.

The first voltage generation circuit 16 generates a first internal voltage VIN1 having a first voltage level in a program pulse application operation duration and a verification/read operation duration.

The second voltage generation circuit 18 generates a second internal voltage VIN2 having a voltage level greater than or equal to a second voltage level in the program pulse application operation duration. In addition, the second voltage generation circuit 18 generates the second internal voltage VIN2 having a second voltage level or a third voltage level in the verification/read operation duration. The second voltage level is a voltage level higher than the first voltage level. The third voltage level is greater than the first voltage level and is less than the second voltage level.

In such a case, the second internal voltage VIN2 is a voltage supplied to generate a program pulse applied to a program target word line in the program pulse application operation duration. Accordingly, the second internal voltage VIN2 is not available for other purposes in the program pulse application operation duration. However, the second internal voltage VIN2 needs not to be supplied to generate the program pulse in the verification/read operation period. Accordingly, the second internal voltage VIN2 is applied to plurality of discharge control circuits 21 to 26 in the verification/read operation period.

More specifically, the operation control circuit 12 sets, to the first voltage level or a disable level, a discharge control signal of a first group applied to a discharge control circuit of the first group physically adjacent to the ground voltage (VSS) terminal among the six discharge control circuits 21 to 26 included in the memory cell array 2.

In addition, the operation control circuit 12 sets a discharge control signal of a second group, which is applied to a discharge control circuit of the second group physically further away from the ground voltage (VSS) terminal than the discharge control circuit of the first group among the six discharge control circuits 21 to 26 included in the memory cell array 2, to a voltage level between the first voltage level and the second voltage level or the disable level. The second voltage level is greater than the first voltage level. That is, the operation control circuit 12 sets the discharge control signal of the second group to the first voltage level, the second voltage level, a third voltage level that is greater than the first voltage level and is less than the second voltage level, or the disable level.

In such a case, setting the discharge control signal of the first group or the second group to the disable level by the operation control circuit 12 means disconnecting a connection between the common source line of a plane of the first group or the second group and the ground voltage (VSS) terminal, that is, controlling no current to flow from the common source line of the plane of the first group or the second group to the ground voltage (VSS) terminal. For example, the disable level is a ground voltage (VSS) level less than the first voltage level.

According to an embodiment, the plane selection circuit 10 selects both the plane of the first group and the plane of the second group as verification/read operation targets.

In this embodiment, when the plane selection circuit 10 selects both the plane of the first group and the plane of the second group as the verification/read operation targets, since current is being discharged from the common source line of the plane of the first group to the ground voltage (VSS) terminal in response to the discharge control signal of the first group set to the first voltage level, the operation control circuit 12 needs to control the discharge control signal of the second group to have a sufficiently higher voltage level than the discharge control signal of the first group in order to stably discharge the current from the common source line of the plane of the second group to the ground voltage (VSS) terminal.

Accordingly, the operation control circuit 12 sets the discharge control signal of the first group to the first voltage level, and sets the discharge control signal of the second group to the second voltage level. That is, the operation control circuit 12 receives, from the first voltage generation circuit 16, the first internal voltage VIN1 set to the first voltage level, and sets the discharge control signal of the first group to the first voltage level. In addition, the operation control circuit 12 receives, from the second voltage generation circuit 18, the second internal voltage VIN2 set to the second voltage level, and sets the discharge control signal of the second group to the second voltage level.

In this way, since the operation control circuit 12 sets the discharge control signal of the second group to the second voltage level, the occurrence of source line bouncing in the common source line of the plane of the second group can be minimized.

According to another embodiment, the plane selection circuit 10 selects the plane of the first group as the verification/read operation target and selects the plane of the second group to be in the idle state.

In this embodiment, when the plane selection circuit 10 selects the plane of the first group as the verification/read operation target and selects the plane of the second group to be in the idle state, the operation control circuit 12 sets the discharge control signal of the first group to the first voltage level and sets the discharge control signal of the second group to the disable level. That is, the operation control circuit 12 receives, from the first voltage generation circuit 16, the first internal voltage VIN1 set to the first voltage level, and sets the discharge control signal of the first group to the first voltage level.

In such a case, setting the discharge control signal of the second group to the disable level means disconnecting a connection between the common source line of the plane of the second group and the ground voltage (VSS) terminal, that is, controlling no current to flow from the common source line of the plane of the second group to the ground voltage (VSS) terminal.

In this way, since the operation control circuit 12 sets the discharge control signal of the first group to the first voltage level in the state of setting the discharge control signal of the second group to the disable level, the occurrence of source line bouncing in the common source line of the plane of the first group can be minimized.

According to another embodiment, the plane selection circuit 10 selects the plane of the second group as the verification/read operation target and selects the plane of the first group to be in the idle state.

In this embodiment, when the plane selection circuit 10 selects the plane of the second group as the verification/read operation target and selects the plane of the first group to be in the idle state, the operation control circuit 12 sets the discharge control signal of the second group to the third voltage level and sets the discharge control signal of the first group to the disable level. That is, the operation control circuit 12 receives, from the second voltage generation circuit 18, the second internal voltage VIN2 set to the third voltage level and sets the discharge control signal of the second group to the second voltage level.

In such a case, setting the discharge control signal of the first group to the disable level means disconnecting a connection between the common source line of the plane of the first group and the ground voltage (VSS) terminal, that is, controlling no current to flow from the common source line of the plane of the first group to the ground voltage (VSS) terminal. That is, when the plane selection circuit 10 selects the plane of the first group to be in the idle state and selects the plane of the second group as the verification/read operation target, since no current is being discharged from the common source line of the plane of the first group to the ground voltage (VSS) terminal, even though the operation control circuit 12 sets the discharge control signal of the second group to the third voltage level greater than the first voltage level but less than the second voltage level, the discharge control circuit of the second group stably discharges current to the ground voltage (VSS) terminal.

In this way, since the operation control circuit 12 sets the discharge control signal of the second group to the third voltage level, the occurrence of source line bouncing in the common source line of the plane of the second group can be minimized.

According to further another embodiment, the plane selection circuit 10 selects one of the plane of the first group and the plane of the second group as the program pulse application operation target and selects the plane of the remaining group as the verification/read operation target.

In this embodiment, when the plane selection circuit 10 selects one of the plane of the first group and the plane of the second group as the program pulse application operation target, only the first internal voltage VIN1 is used because the second internal voltage VIN2 needs to be supplied to generate the program pulse. In addition, the common source line of the plane of any group selected as the program pulse application operation target needs to be connected to the ground voltage (VSS) terminal.

Accordingly, the operation control circuit 12 sets the discharge control signal of the first group to the first voltage level, and sets the discharge control signal of the second group to the first voltage level. That is, the operation control circuit 12 receives, from the first voltage generation circuit 16, the first internal voltage VIN1 set to the first voltage level, and sets the discharge control signal of the first group and the discharge control signal of the second group to the first voltage level.

Referring to FIGS. 2A and 2B together with FIG. 1, it can be seen how the physical positions of the six discharge control circuits 21 to 26 respectively corresponding to the six planes PLANE<1:6> are changed.

First, referring to FIG. 2A together with FIG. 1, it is illustrated that among the six planes PLANE<1:6>, the first plane PLANE1, the second plane PLANE2, and the fifth plane PLANE5 are arranged on the left, whereas the third plane PLANE3, the fourth plane PLANE4, and the sixth plane PLANE6 are arranged on the right. Additionally, among the six planes PLANE<1:6>, the first plane PLANE1 and the third plane PLANE3 are arranged at the top, the fifth plane PLANE5 and the sixth plane PLANE6 are arranged at the bottom, and the second plane PLANE2 and the fourth plane PLANE4 are arranged between the top and the bottom. Further, the ground voltage (VSS) terminal is adjacent to the top.

Moreover, the DIS_CON1 21, the DIS_CON2 22, the DIS_CON3 23, and the DIS_CON4 24 are physically adjacent to the lower portions of the first plane PLANE1, the second plane PLANE2, the third plane PLANE3, and the fourth plane PLANE4, respectively. Further, the DIS_CON5 25 and the DIS_CON6 26 are physically adjacent to the upper portions of the fifth plane PLANE5 and the sixth plane PLANE6, respectively.

Therefore, the DIS_CON2 22 and the DIS_CON5 25 are considered as being physically adjacent to each other, whereas the DIS_CON1 21 and the DIS_CON2 22 are considered as not being physically adjacent to each other. In addition, the DIS_CON1 21 is considered as being adjacent to the ground voltage (VSS) terminal, whereas the DIS_CON2 22 and the DIS_CON5 25 are considered as not being adjacent to the ground voltage (VSS) terminal. That is, the DIS_CON2 22 and the DIS_CON5 25 are considered as being physically further away from the ground voltage (VSS) terminal than the DIS_CON1 21.

Likewise, the DIS_CON4 24 and the DIS_CON6 26 are considered as being physically adjacent to each other, whereas the DIS_CON3 23 and the DIS_CON4 24 are considered as not being physically adjacent to each other. In addition, the DIS_CON3 23 is considered as being adjacent to the ground voltage (VSS) terminal, whereas the DIS_CON4 24 and the DIS_CON6 26 are considered as not being adjacent to the ground voltage (VSS) terminal. That is, the DIS_CON4 24 and the DIS_CON6 26 are considered as being physically further away from the ground voltage (VSS) terminal than the DIS_CON3 23.

In summary, the operation control circuit 12 classifies the DIS_CON1 21 and the DIS_CON3 23, which are considered as being adjacent to the ground voltage (VSS) terminal, as discharge control circuits of the first group. Accordingly, the operation control circuit 12 sets, to the first voltage level, the first discharge control signal DISP1 applied to the DIS_CON1 21 and the third discharge control signal DISP3 applied to the DIS_CON3 23. In such a case, to set the first discharge control signal DISP1 and the third discharge control signal DISP3 to the first voltage level, the operation control circuit 12 receives the first internal voltage VIN1 generated by the first voltage generation circuit 16.

In addition, the operation control circuit 12 classifies the DIS_CON2 22, the DIS_CON4 24, the DIS_CON5 25, and the DIS_CON6 26, which are considered as not being adjacent to the ground voltage (VSS) terminal, as discharge control circuits of the second group. Accordingly, the operation control circuit 12 sets, to a voltage level between the first voltage level and the second voltage level, the second discharge control signal DISP2 applied to the DIS_CON2 22, the fourth discharge control signal DISP4 applied to the DIS_CON4 24, the fifth discharge control signal DISP5 applied to the DIS_CON5 25, and the sixth discharge control signal DISP6 applied to the DIS_CON6 26. The second voltage level is greater than the first voltage level. That is, the operation control circuit 12 sets the second discharge control signal DISP2, the fourth discharge control signal DISP4, the fifth discharge control signal DISP5, and the sixth discharge control signal DISP6 to the first voltage level, the second voltage level, or the third voltage level. The third voltage level is greater than the first voltage level and is less than the second voltage level.

In such a case, to set the second discharge control signal DISP2, the fourth discharge control signal DISP4, the fifth discharge control signal DISP5, and the sixth discharge control signal DISP6 to the first voltage level, the operation control circuit 12 receives the first internal voltage VIN1 generated by the first voltage generation circuit 16. In addition, to set the second discharge control signal DISP2, the fourth discharge control signal DISP4, the fifth discharge control signal DISP5, and the sixth discharge control signal DISP6 to the second voltage level or the third voltage level, the operation control circuit 12 receives the second internal voltage VIN2 generated by the second voltage generation circuit 18.

In this way, the operation control circuit 12 adjusts the levels of the discharge control signals DISP< 1:6> based on the physical distance from the ground voltage (VSS) terminal, thereby minimizing the occurrence of source line bouncing in the common source line of a plane not physically adjacent to the ground voltage (VSS) terminal.

Referring to FIG. 2B together with FIG. 1, it is shown that among the six planes PLANE<1:6>, the first plane PLANE1, the second plane PLANE2, and the fifth plane PLANE5 are arranged on the left, whereas the third plane PLANE3, the fourth plane PLANE4, and the sixth plane PLANE6 are arranged on the right. It is also shown that among the six planes PLANE<1:6>, the first plane PLANE1 and the third plane PLANE3 are arranged at the top, the fifth plane PLANE5 and the sixth plane PLANE6 are arranged at the bottom, and the second plane PLANE2 and the fourth plane PLANE4 are arranged between the top and the bottom. Further, the ground voltage (VSS) terminal is adjacent to the top.

Additionally, the DIS_CON1 21 and the DIS_CON3 23 are physically adjacent to the lower portions of the first plane PLANE1 and the third plane PLANE3, respectively. The DIS_CON2 22, the DIS_CON4 24, the DIS_CON5 25, and the DIS_CON6 26 are physically adjacent to the upper portions of the second plane PLANE2, the fourth plane PLANE4, the fifth plane PLANE5, and the sixth plane PLANE6, respectively.

Therefore, the DIS_CON1 21 and the DIS_CON2 22 are considered as being physically adjacent to each other, whereas the DIS_CON2 22 and the DIS_CON5 25 are considered as not being physically adjacent to each other. In addition, the DIS_CON1 21 and the DIS_CON2 22 are considered as being adjacent to the ground voltage (VSS) terminal, whereas the DIS_CON5 25 is considered as not being adjacent to the ground voltage (VSS) terminal. That is, the DIS_CON5 25 is physically further away from the ground voltage (VSS) terminal than the DIS_CON1 21 and the DIS_CON2 22.

Likewise, the DIS_CON3 23 and the DIS_CON4 24 are considered as being physically adjacent to each other, whereas the DIS_CON4 24 and the DIS_CON6 26 are considered as not being physically adjacent to each other. In addition, the DIS_CON3 23 and the DIS_CON4 24 are considered as being adjacent to the ground voltage (VSS) terminal, whereas the DIS_CON6 26 is considered as not being adjacent to the ground voltage (VSS) terminal. That is, the DIS_CON6 26 is considered as being physically further away from the ground voltage (VSS) terminal than the DIS_CON3 23 and the DIS_CON4 24.

In summary, the operation control circuit 12 classifies the DIS_CON1 21, the DIS_CON2 22, the DIS_CON3 23, and the DIS_CON4 24, which are considered as being adjacent to the ground voltage (VSS) terminal, as discharge control circuits of the first group. Accordingly, the operation control circuit 12 sets, to the first voltage level, the first discharge control signal DISP1 applied to the DIS_CON1 21, the second discharge control signal DISP2 applied to the DIS_CON2 22, the third discharge control signal DISP3 applied to the DIS_CON3 23, and the fourth discharge control signal DISP4 applied to the DIS_CON4 24. In such a case, to set the first discharge control signal DISP1, the second discharge control signal DISP2, the third discharge control signal DISP3, and the fourth discharge control signal DISP4 to the first voltage level, the operation control circuit 12 receives the first internal voltage VIN1 generated by the first voltage generation circuit 16.

In addition, the operation control circuit 12 classifies the DIS_CON5 25 and the DIS_CON6 26, which are considered as not being adjacent to the ground voltage (VSS) terminal, as discharge control circuits of the second group. Accordingly, the operation control circuit 12 sets, to a voltage level between the first voltage level and the second voltage level, the fifth discharge control signal DISP5 applied to the DIS_CON5 25 and the sixth discharge control signal DISP6 applied to the DIS_CON6 26. The second voltage level is greater than the first voltage level. That is, the operation control circuit 12 sets the fifth discharge control signal DISP5 and the sixth discharge control signal DISP6 to the first voltage level, the second voltage level, or the third voltage level. The third voltage level is greater than the first voltage level and is less than the second voltage level.

In such a case, to set the fifth discharge control signal DISP5 and the sixth discharge control signal DISP6 to the first voltage level, the operation control circuit 12 receives the first internal voltage VIN1 generated by the first voltage generation circuit 16. In addition, to set the fifth discharge control signal DISP5 and the sixth discharge control signal DISP6 to the second voltage level or the third voltage level, the operation control circuit 12 receives the second internal voltage VIN2 generated by the second voltage generation circuit 18.

In this way, the operation control circuit 12 adjusts the levels of the discharge control signals DISP<1:6> based on the physical distance from the ground voltage (VSS) terminal, thereby minimizing the occurrence of source line bouncing in the common source line of a plane not physically adjacent to the ground voltage (VSS) terminal.

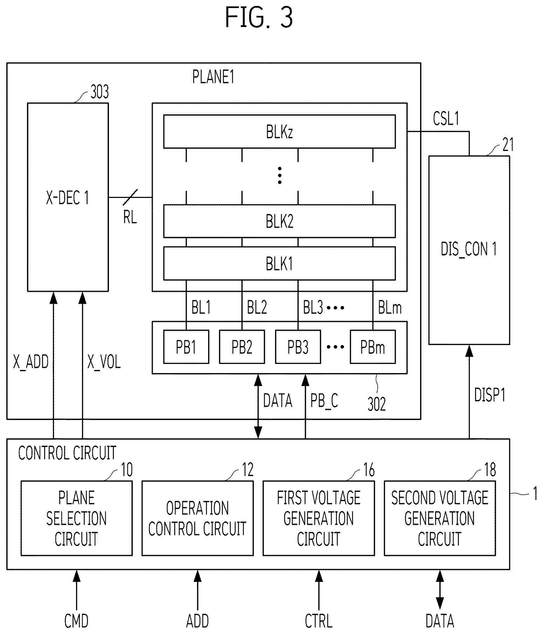

FIG. 3 is a diagram for describing the configuration of each of the plurality of planes included in the nonvolatile memory device in accordance with the embodiment of the present disclosure.

Referring to FIG. 3, among the plurality of planes PLANE<1:6> included in the nonvolatile memory device illustrated in FIG. 1, the first plane PLANE1 includes a plurality of memory blocks BLK1-BLKz, a row decoder (X-DEC1) 303, and a page buffer circuit 302.

Specifically, the X-DEC1 303 is connected to the plurality of memory blocks BLK1-BLKz through row lines RL. The row lines RL include at least one drain select line Drain Select Line, a plurality of word lines Word Line, and at least one source select line Source Select Line.

In addition, the X-DEC1 303 selects one of the plurality of memory blocks BLK1-BLKz in response to a row address X_ADD provided from the control circuit 1. The X-DEC1 303 transmits an operating voltage X_VOL provided from the control circuit 1 to the row lines RL connected to the memory block selected from the plurality of memory blocks BLK1-BLKz.

The plurality of memory blocks BLK1-BLKz are connected to the page buffer circuit 302 through bit lines BL1-BLm. The page buffer circuit 302 includes a plurality of page buffers PB1-PBm connected to the bit lines BL1-BLm, respectively. The page buffer circuit 302 receives a page buffer control signal PB_C from the control circuit 1, and transmits and receives a data signal DATA to and from the control circuit 1. In response to the page buffer control signal PB_C, the page buffer circuit 302 controls bit lines arranged in the plurality of memory blocks BLK1-BLKz. For example, the page buffer circuit 302 detects data stored in memory cells of the plurality of memory blocks BLK1-BLKz by detecting signals of the bit lines BL1-BLm of the plurality of memory blocks BLK1-BLKz in response to the page buffer control signal PB_C, and transmits the data signal DATA to the control circuit 1 according to the detected data. The page buffer circuit 302 applies signals to the bit lines BL1-BLm based on the data signal DATA received from the control circuit 1, in response to the page buffer control signal PB_C, and thus writes data into the memory cells of the plurality of memory blocks BLK1-BLKz. The page buffer circuit 302 writes data into a memory cell connected to a word line activated by the X-DEC1 303 or reads the data from the memory cell.

The DIS_CON1 21 is connected to the plurality of memory blocks BLK1-BLKz through a first common source line CSL1. The DIS_CON1 21 receives the first discharge control signal DISP1 from the control circuit 1. The DIS_CON1 21 electrically connects the first common source line CSL1 to the ground voltage (VSS) terminal in response to the first discharge control signal DISP1.

The control circuit 1 receives a command signal CMD, an address signal ADD, and a control signal CTRL from the outside of the nonvolatile memory device, and transmits and receives data DATA to and from an external device of the nonvolatile memory device, such as a memory controller. The control circuit 1 outputs signals for writing data into the plurality of memory blocks BLK1-BLKz or reading data from the plurality of memory blocks BLK1-BLKz based on the command signal CMD, the address signal ADD, and the control signal CTRL. The signals, for example, include the row address X_ADD, the page buffer control signal PB_C, and the first discharge control signal DISP1. The control circuit 1 generates various voltages including the operating voltage X_VOL required in the nonvolatile memory device.

FIG. 3 discloses only the detailed configuration of the first plane PLANE1 among the plurality of planes PLANE<1:6>, but the other planes PLANE<2:6> are also configured in the same form as the detailed configuration of the first plane PLANE1.

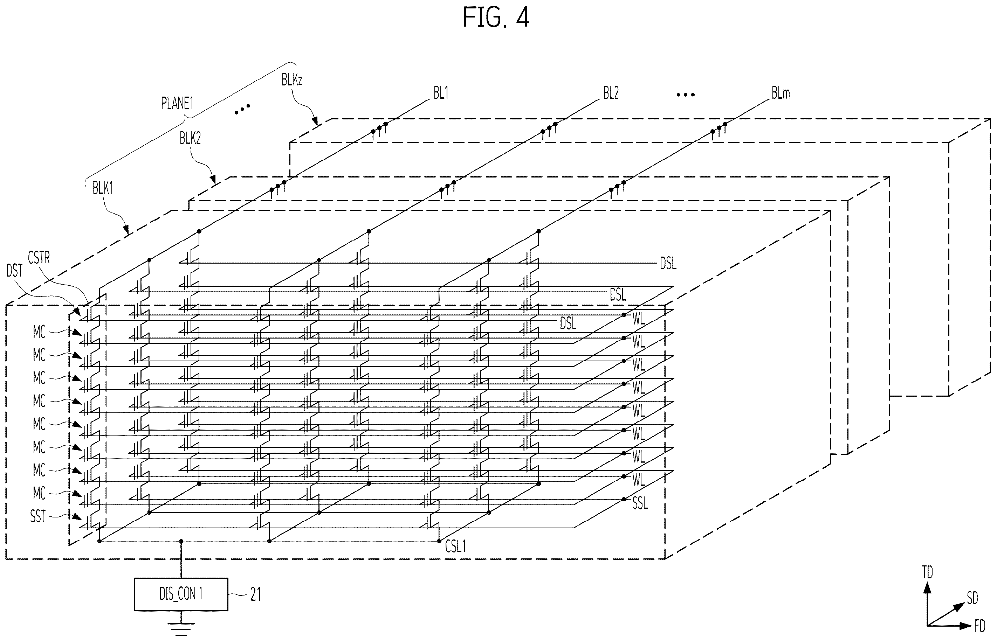

FIG. 4 is a diagram for describing the structure of each of the plurality of memory blocks included in the nonvolatile memory device in accordance with the embodiment of the present disclosure.

Referring to FIG. 4, in the first plane PLANE1 among the plurality of planes PLANE<1:6> included in the nonvolatile memory device illustrated in FIG. 1, each of the plurality of memory blocks BLK1-BLKz includes a plurality of cell strings CSTR connected between the plurality of bit lines BL1-BLm and the common source line CSL.

The bit lines BL1 to BLm may extend in the second direction SD, and may be arranged in the first direction FD. A plurality of cell strings CSTR may be coupled in parallel to each of the bit lines BL1 to BLm. The cell strings CSTR may be coupled in common to the one common source line CSL. The plurality of cell strings CSTR may be disposed between the plurality of bit lines BL1 to BLm and the one common source line CSL.

Each of the cell strings CSTR may include a drain select transistor DST which is coupled to a bit line BL, a source select transistor SST which is coupled to the common source line CSL, and a plurality of memory cells MC which are coupled between the drain select transistor DST and the source select transistor SST. The drain select transistor DST, the memory cells MC, and the source select transistor SST may be coupled in series in the third direction TD.

Drain select lines DSL, a plurality of word lines WL, and a source select line SSL may be disposed between the bit lines BL1 to BLm and the common source line CSL in the third direction TD. The drain select lines DSL may be coupled to the gates of corresponding drain select transistors DST, respectively. The word lines WL may be coupled to the gates of corresponding memory cells MC, respectively. The source select line SSL may be coupled to the gates of source select transistors SST. Memory cells MC which are coupled in common to one word line WL may constitute one page.

The bit lines BL1 to BLm and the common source line CSL may be coupled in common to the memory blocks BLK1 to BLKn. That is, the memory blocks BLK1 to BLKn may share the plurality of bit lines BL1 to BLm and the one common source line CSL. Each of the memory blocks BLK1 to BLKn, however, may have its own drain select lines DSL, a plurality of word lines WL and the source select line SSL. The discharge control circuit 21 may be coupled to the common source line CSL.

For reference, two directions that are parallel to the top surface of a substrate and intersect with each other are defined as a first direction FD and a second direction SD, respectively, and a direction that vertically protrudes from the top surface of the substrate is defined as a third direction TD. For example, the first direction FD may correspond to the extending direction of word lines, and the second direction SD may correspond to the extending direction of bit lines. The first direction FD and the second direction SD may substantially perpendicularly intersect with each other. The third direction TD may correspond to a direction that is perpendicular to the first direction FD and the second direction SD. In the following descriptions, the term 'vertical' or 'vertical direction' has substantially the same meaning as the third direction TD. In the drawings, directions indicated by an arrow and a direction opposite thereto represent the same direction.

FIG. 4 discloses only the detailed configuration of the plurality of memory blocks BLK1-BLKz included in the first plane PLANE1 among the plurality of planes PLANE<1:6>, but the remaining other planes PLANE<2:6> are also configured in the same form as the detailed configuration of the first plane PLANE 1.

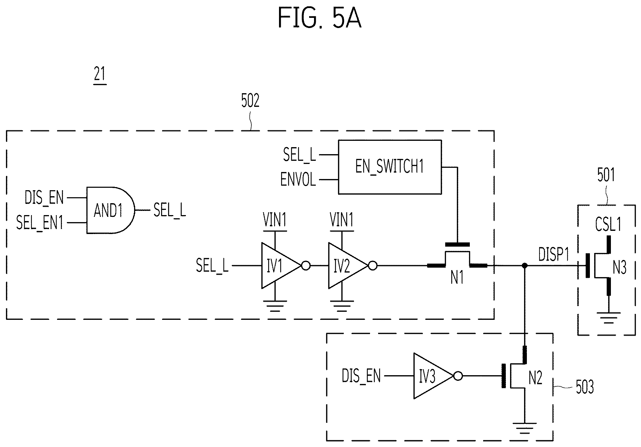

FIG. 5A is a circuit diagram for describing a discharge control circuit of the first group included in the nonvolatile memory device in accordance with the embodiment of the present disclosure.

First, as described with reference to FIGS. 1, 2A, and 2B, the operation control circuit 12 sets, to the first voltage level or the disable level, the discharge control signal of the first group applied to the discharge control circuit of the first group (meaning a discharge control circuit physically closer to the ground voltage (VSS) terminal than the discharge control circuit of the second group) physically adjacent to the ground voltage (VSS) terminal among the six discharge control circuits 21 to 26 included in the memory cell array 2.

FIG. 5A illustrates a detailed circuit configuration of the DIS_CON1 21 based on that the DIS_CON1 21 physically adjacent to the first plane PLANE1 among the plurality of planes PLANE<1:6> is the discharge control circuit of the first group with reference to FIGS. 2A and 2B. However, this is merely for convenience, and each discharge control circuit classified as the discharge control circuit of the first group has a circuit configuration like the circuit configuration illustrated in FIG. 5A. For example, when two discharge control circuits, that is, the DIS_CON1 21 and the DIS_CON3 23 as illustrated in FIG. 2A, are classified as the discharge control circuits of the first group, two circuits as illustrated in FIG. 5A are included in the nonvolatile memory device. For another example, when four discharge control circuits, that is, the DIS_CON1 21, the DIS_CON2 22, the DIS_CON3 23, and the DIS_CON4 24 are classified as the discharge control circuits of the first group as illustrated in FIG. 2B, four circuits as illustrated in FIG. 5A are included in the nonvolatile memory device.

Since it is shown in FIG. 5A that the discharge control circuit of the first group is the DIS_CON1 21, the reference numerals illustrated in the drawing are reference numerals related to the DIS_CON1 21. However, this is merely one embodiment, and when the discharge control circuit of the first group is the DIS_CON3 23, reference numerals illustrated in the drawing are also changed to reference numerals related to the DIS_CON3 23 and applied.

Specifically, the discharge control circuit of the first group includes a first discharge transistor 501, a first level setting unit 502, and a first idle setting unit 503.

The first discharge transistor 501 controls the connection between the common source line of a plane of the first group connected to a drain terminal thereof and the ground voltage (VSS) terminal connected to a source terminal thereof, in response to the discharge control signal of the first group applied to a gate terminal thereof.

That is, the first discharge transistor 501 included in the DIS_CON1 21 classified as the discharge control circuit of the first group controls the connection between the common source line CSL1 of the first plane PLANE1 connected to the drain terminal and the ground voltage (VSS) terminal connected to the source terminal, in response to the first discharge control signal DISP1 applied to the gate terminal.

For example, the first discharge transistor 501 is an NMOS transistor. Accordingly, in response to the first discharge control signal DISP1 being set to the first voltage level, the first discharge transistor 501 connects the common source line CSL1 of the first plane PLANE1 and the ground voltage (VSS) terminal. In response to the first discharge control signal DISP1 being set to the ground voltage (VSS) level, the first discharge transistor 501 disconnects the common source line CSL1 of the first plane PLANE1 and the ground voltage (VSS) terminal.

The first level setting unit 502 sets the discharge control signal of the first group to the level of the first internal voltage in response to the plane of the first group being selected as the verification/read operation target or the program pulse application operation target by the plane selection circuit 10.

That is, the first level setting unit 502 included in the DIS_CON1 21 classified as the discharge control circuit of the first group sets the first discharge control signal DISP1 to the level of the first internal voltage VIN1 in response to the first plane PLANE1 being selected as the verification/read operation target or the program pulse application operation target by the plane selection circuit 10.

The first idle setting unit 503 sets the discharge control signal of the first group to the disable level in response to the plane of the first group being selected to be in the idle state by the plane selection circuit 10.

That is, the first idle setting unit 503 included in the DIS_CON1 21 classified as the discharge control circuit of the first group sets the first discharge control signal DISP1 to the disable level in response to the first plane PLANE1 being selected to be in the idle state by the plane selection circuit 10.

More specifically, the first level setting unit 502 includes an AND gate AND1 for setting the logic level of SEL_L by performing an AND operation on DIS_EN and SEL_EN1, a switch EN_SWITCH1 for transmitting SEL_L when ENVOL is logic high, two inverters IV1 and IV2 for receiving the first internal voltage VIN1 as power to buffer and drive SEL_L, and an NMOS transistor N1 for outputting the SEL_L signal buffered through the two inverters IV1 and IV2 as the first discharge control signal DISP1 in response to an output signal of the EN_SWITCH1 input to a gate thereof.

The first idle setting unit 503 includes an inverter IV3 that inverts DIS_EN and outputs the inverted DIS_EN, and an NMOS transistor N2 for selectively connecting a node of the first discharge control signal DISP1 to the ground voltage (VSS) terminal in response to an output signal of the IV3.

According to an embodiment, when the plane selection circuit 10 selects the first plane PLANE1 classified as the plane of the first group as the verification/read operation target or the program pulse application operation target, the plane selection circuit 10 sets all of SEL_EN1, DIS_EN, and ENVOL to logic high and outputs SEL_EN1, DIS_EN, and ENVOL to the DIS_CON1 21.

In such a case, the first level setting unit 502 sets SEL_L to logic high and the EN_SWITCHI1 sets the N1 to a turn-on state so that SEL_L set to the level of the first internal voltage VIN1 is output as the first discharge control signal DISP1. Since the first internal voltage VIN1 has the first voltage level, the first discharge control signal DISP1 has the first voltage level.

The first idle setting unit 503 sets the N2 to a turn-off state so that the node of the first discharge control signal DISP1 is not connected to the ground voltage (VSS) terminal.

In response to the first discharge control signal DISP1 set to the first voltage level, the first discharge transistor 501 connects the common source line CSL1 of the first plane PLANE1 to the ground voltage (VSS) terminal by setting the N3 to a turn-on state.

According to another embodiment, when the plane selection circuit 10 selects the first plane PLANE1 classified as the plane of the first group to be in the idle state, the plane selection circuit 10 sets all of SEL_EN1, DIS_EN, and ENVOL to logic low and output SEL_EN1, DIS_EN, and ENVOL to the DIS_CON1 21.

In such a case, the first level setting unit 502 sets SEL_L to logic low and the EN_SWITCH1 sets the N1 to a turn-off state so that SEL_L set to the ground voltage (VSS) level is not output as the first discharge control signal DISP1.

The first idle setting unit 503 sets the N2 to a turn-on state so that the node of the first discharge control signal DISP1 is connected to the ground voltage (VSS) terminal. That is, the first discharge control signal DISP1 is set to the ground voltage (VSS) level being the disable level.

The first discharge transistor 501 sets the N3 to a turn-off state in response to the first discharge control signal DISP1 set to the ground voltage (VSS) level so that the common source line CSL1 of the first plane PLANE1 is not connected to the ground voltage (VSS) terminal.

For reference, SEL_EN1, DIS_EN, and ENVOL output from the plane selection circuit 10 to the DIS_CON1 21 are signals whose logic levels are determined according to the value of the first plane selection signal SEL_P1 described with reference to FIGS. 1, 2A, and 2B. In addition, ENVOL output from the plane selection circuit 10 to the DIS_CON1 21 is set to a voltage level greater than the first internal voltage VIN1 by a threshold voltage level or more in an activated state. That is, ENVOL turns on the N1 so that SEL_L set to the first voltage level in the activated state is transmitted as the first discharge control signal DISP1 without loss.

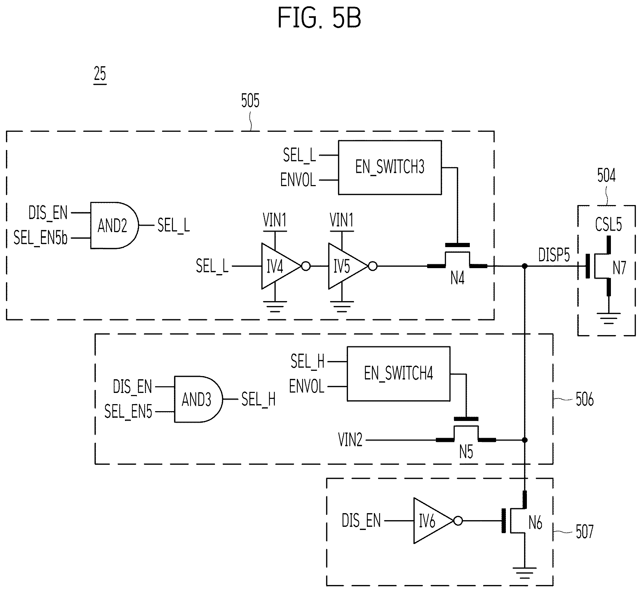

FIG. 5B is a circuit diagram for describing a discharge control circuit of the second group included in the nonvolatile memory device in accordance with an embodiment of the present disclosure.

First, as described with reference to FIGS. 1, 2A, and 2B, the operation control circuit 12 sets the discharge control signal of the second group, which is applied to the discharge control circuit of the second group physically further away from the ground voltage (VSS) terminal than the discharge control circuit of the first group among the six discharge control circuits 21 to 26 included in the memory cell array 2, to a voltage level between the first voltage level and the second voltage level or the disable level. The second voltage level is greater than the first voltage level. That is, the operation control circuit 12 sets the discharge control signal of the second group to the first voltage level, the second voltage level, a third voltage level that is greater than the first voltage level and is less than the second voltage level, or the disable level.

FIG. 5B illustrates a detailed circuit configuration of the DIS_CON5 25 based on that the DIS_CON5 25 physically adjacent to the fifth plane PLANE5 among the plurality of planes PLANE<1:6> is the discharge control circuit of the second group with reference to FIGS. 2A and 2B. However, this is merely for convenience, and each discharge control circuit classified as the discharge control circuit of the second group has a circuit configuration like the circuit configuration illustrated in FIG. 5B. For example, when four discharge control circuits, that is, the DIS_CON2 22, the DIS_CON4 24, the DIS_CON5 25, and the DIS_CON6 26 are classified as the discharge control circuits of the second group as illustrated in FIG. 2A, four circuits in the form illustrated in FIG. 5B are included in the nonvolatile memory device. For another example, when two discharge control circuits, that is, the DIS_CON5 25 and the DIS_CON6 26 as illustrated in FIG. 2B, are classified as the discharge control circuits of the second group, two circuits as illustrated in FIG. 5B are included in the nonvolatile memory device.

Since in FIG. 5B the discharge control circuit of the second group is the DIS_CON5 25, it can be seen that reference numerals illustrated in the drawing are reference numerals related to the DIS_CON5 25. However, this is merely one embodiment, and when the discharge control circuit of the second group is the DIS_CON6 26, reference numerals illustrated in the drawing are also changed to reference numerals related to the DIS_CON6 26 and applied.

Specifically, the discharge control circuit of the second group includes a second discharge transistor 504, a second level setting unit 505, a third level setting unit 506, and a second idle setting unit 507.

The second discharge transistor 504 controls the connection between the common source line of a plane of the second group connected to a drain terminal thereof and the ground voltage (VSS) terminal connected to a source terminal thereof, in response to the discharge control signal of the second group applied to a gate terminal thereof.

That is, the second discharge transistor 504 included in the DIS_CON5 25 classified as the discharge control circuit of the second group controls the connection between the common source line CSL5 of the fifth plane PLANE5 connected to the drain terminal and the ground voltage (VSS) terminal connected to the source terminal, in response to the fifth discharge control signal DISP5 applied to the gate terminal.

For example, the second discharge transistor 504 is an NMOS transistor. Accordingly, in response to the fifth discharge control signal DISP5 being set to the first voltage level, the second voltage level, or the third voltage level, the second discharge transistor 504 connects the common source line CSL5 of the fifth plane PLANE5 and the ground voltage (VSS) terminal. In response to the fifth discharge control signal DISP5 being set to the ground voltage (VSS) level, the second discharge transistor 504 disconnects the connection between the common source line CSL5 of the fifth plane PLANE5 and the ground voltage (VSS) terminal.

The second level setting unit 505 sets the discharge control signal of the second group to the level of the second internal voltage VIN2 in response to the plane of the second group being selected as the verification/read operation target by the plane selection circuit 10.

That is, the second level setting unit 505 included in the DIS_CON5 25 classified as the discharge control circuit of the second group sets the fifth discharge control signal DISP5 to the level of the second internal voltage VIN2 in response to the fifth plane PLANE5 being selected as the verification/read operation target by the plane selection circuit 10.

The third level setting unit 506 sets the discharge control signal of the second group to the level of the first internal voltage VIN1 in response to the plane of the second group being selected as a program operation target by the plane selection circuit 10.

That is, the third level setting unit 506 included in the DIS_CON5 25 classified as the discharge control circuit of the second group sets the fifth discharge control signal DISP5 to the level of the first internal voltage VIN1 in response to the fifth plane PLANE5 being selected as the program operation target by the plane selection circuit 10.

The second idle setting unit 507 sets the discharge control signal of the second group to the disable level in response to the plane of the second group being selected to be in the idle state by the plane selection circuit 10.

That is, the second idle setting unit 507 included in the DIS_CON5 25 classified as the discharge control circuit of the second group sets the fifth discharge control signal DISP5 to the disable level in response to the fifth plane PLANE5 being selected to be in the idle state by the plane selection circuit 10.

More specifically, the second level setting unit 505 includes an AND gate AND2 for setting the logic level of SEL_L by performing an AND operation on DIS_EN and SEL_EN5b, a switch EN_SWITCH3 for transmitting SEL_L when ENVOL is logic high, two inverters IV4 and IV5 for receiving the first internal voltage VIN1 as power to buffer and drive SEL_L, and an NMOS transistor N4 for outputting the SEL_L signal buffered through the two inverters IV4 and IV5 as the fifth discharge control signal DISP5 in response to an output signal of the EN_SWITCH3 input to a gate thereof.

The third level setting unit 506 includes an AND gate AND3 for setting the logical level of SEL_H by performing an AND operation on DIS_EN and SEL_EN5, a switch EN_SWITCH4 for transmitting SEL_H when ENVOL is logic high, and an NMOS transistor N5 for outputting the second internal voltage VIN2 as the fifth discharge control signal DISP5 in response to an output signal of the EN_SWITCH4 input to a gate thereof.

The second idle setting unit 507 includes an inverter IV6 that inverts DIS_EN and outputs the inverted DIS_EN, and an NMOS transistor N6 for selectively connecting a node of the fifth discharge control signal DISP5 to the ground voltage (VSS) terminal in response to an output signal of the IV6.

According to an embodiment, when the plane selection circuit 10 selects the fifth plane PLANE5 classified as the plane of the second group as the verification/read operation target, the plane selection circuit 10 sets all of SEL_EN5, DIS_EN, and ENVOL to logic high and outputs SEL_EN5, DIS_EN, and ENVOL to the DIS_CON5 25.

In such a case, the second level setting unit 505 sets SEL_L to logic low and the EN_SWITCH3 sets the N4 to a turn-off state so that SEL_L set to the ground voltage (VSS) level is not output as the fifth discharge control signal DISP5.

The third level setting unit 506 sets SEL_H to logic high and the EN_SWITCH4 sets the N5 to a turn-on state, thereby setting the fifth discharge control signal DISP5 to the level of the second internal voltage VIN2. Since the second internal voltage VIN2 has the second voltage level or the third voltage level, the fifth discharge control signal DISP5 has the second voltage level or the third voltage level.

The second idle setting unit 507 sets the N6 to a turn-off state so that the node of the fifth discharge control signal DISP5 is not connected to the ground voltage (VSS) terminal.

The second discharge transistor 504 sets the N7 to a turn-on state in response to the fifth discharge control signal DISP5 set to the second voltage level or the third voltage level so that the common source line CSL5 of the fifth plane PLANE5 is connected to the ground voltage (VSS) terminal.

According to another embodiment, when the plane selection circuit 10 selects the fifth plane PLANE5 classified as the plane of the second group as the program operation target, the plane selection circuit 10 sets SEL_EN5 to logic low, sets both DIS_EN and ENVOL to logic high, and outputs SEL_EN5, DIS_EN, and ENVOL to the DIS_CON5 25.

In such a case, the second level setting unit 505 sets SEL_L to logic high and the EN_SWITCH3 sets the N4 to a turn-on state so that SEL_L set to the level of the first internal voltage VIN1 is output as the fifth discharge control signal DISP5. Since the first internal voltage VIN1 has the first voltage level, the fifth discharge control signal DISP5 has the first voltage level.

The third level setting unit 506 sets SEL_H to logic low and the EN_SWITCH4 sets the N5 to a turn-off state so that the fifth discharge control signal DISP5 is not set to the level of the second internal voltage VIN2.

The second idle setting unit 507 sets the N6 to a turn-off state so that the node of the fifth discharge control signal DISP5 is not connected to the ground voltage (VSS) terminal.

The second discharge transistor 504 sets the N7 to a turn-on state in response to the fifth discharge control signal DISP5 set to the first voltage level so that the common source line CSL5 of the fifth plane PLANE5 is connected to the ground voltage (VSS) terminal.

According to another embodiment, when the plane selection circuit 10 selects the fifth plane PLANE5 classified as the plane of the second group to be in the idle state, the plane selection circuit 10 sets all of SEL_EN5, DIS_EN, and ENVOL to logic low and outputs SEL_EN5, DIS_EN, and ENVOL to the DIS_CON5 25.

In such a case, the second level setting unit 505 sets SEL_L to logic low and the EN_SWITCH3 sets the N4 to a turn-off state so that SEL_L set to the ground voltage (VSS) level is not output as the fifth discharge control signal DISP5.

The third level setting unit 506 sets SEL_H to logic low and the EN_SWITCH4 sets the N5 to a turn-off state so that the fifth discharge control signal DISP5 is not set to the level of the second internal voltage VIN2.

The second idle setting unit 507 sets the N6 to a turn-on state so that the node of the fifth discharge control signal DISP5 is connected to the ground voltage (VSS) terminal. That is, the fifth discharge control signal DISP5 is set to the ground voltage (VSS) level being the disable level.

The second discharge transistor 504 sets the N7 to a turn-off state in response to the fifth discharge control signal DISP5 set to the ground voltage (VSS) level so that the common source line CSL5 of the fifth plane PLANE5 is not connected to the ground voltage (VSS) terminal.

For reference, SEL_EN5, DIS_EN, and ENVOL output from the plane selection circuit 10 to the DIS_CON5 25 are signals whose logic levels are determined according to the value of the fifth plane selection signal SEL_P5 described with reference to FIGS. 1, 2A, and 2B. In addition, ENVOL output from the plane selection circuit 10 to the DIS_CON5 25 is set to a voltage level greater than the second internal voltage VIN2 by a threshold voltage level or more in an activated state. That is, ENVOL turns on the N5 so that the second internal voltage VIN2 set to the second voltage level in the activated state is transmitted as the fifth discharge control signal DISP5 without loss.

Referring to FIG. 5A and FIG. 5B together, it is shown that the discharge control signal of the first group used to control the first discharge transistor 501 included in the discharge control signal of the first group has the first voltage level or the ground voltage (VSS) level. That is, the first discharge control signal DISP1 applied to the gate of the N3 included in the first discharge transistor 501 has the first voltage level or the ground voltage (VSS) level.

The discharge control signal of the second group used to control the second discharge transistor 504 included in the discharge control circuit of the second group has the second voltage level, the third voltage level, or the ground voltage (VSS) level. That is, the fifth discharge control signal DISP5 applied to the gate of the N7 included in the second discharge transistor 504 has the second voltage level, the third voltage level, or the ground voltage (VSS) level.

Each of the second voltage level and the third voltage level is a voltage level greater than the first voltage level.

Accordingly, the second discharge transistor 504 included in the discharge control circuit of the second group is a high-voltage transistor having a thicker oxide film thickness than the first discharge transistor 501 included in the discharge control circuit of the first group. That is, the N7 included in the second discharge transistor 504 is a high-voltage NMOS transistor having a thicker oxide film thickness than the N3 included in the first discharge transistor 501.

The embodiments of the present disclosure described above are not limited by the aforementioned embodiments and the accompanying drawings, and it will be apparent to those skilled in the art that various replacements, modifications, and changes can be made without departing from the technical scope of the present disclosure. Furthermore, the embodiments may be combined to form additional embodiments.

For example, the position and the type of a logic gate and a transistor illustrated in the aforementioned embodiments can be differentially realized according to the polarity of an inputted signal.

## Claims

1. A nonvolatile memory device comprising:
N planes each comprising a plurality of memory blocks;
N discharge control circuits adjacent to the N planes, respectively, and configured to connect each common source line of the N planes and a ground voltage terminal in response to each one of N discharge control signals;
a plane selection circuit configured to select K planes of the N planes; and
an operation control circuit configured to adjust voltage levels of K discharge control signals according to a distance difference between the ground voltage terminal and each of K discharge control circuits corresponding to the K planes, among the N discharge control circuits,
wherein N is a natural number greater than or equal to 2, and K is a natural number less than or equal to N and greater than or equal to 1.

2. The nonvolatile memory device of claim 1, wherein the operation control circuit sets, to a first voltage level, a discharge control signal of a first group applied to a discharge control circuit of the first group adjacent to the ground voltage terminal among the N discharge control circuits, and
sets, to a voltage level between the first voltage level and a second voltage level greater than the first voltage level, a discharge control signal of a second group applied to a discharge control circuit of the second group further away from the ground voltage terminal than the discharge control circuit of the first group among the N discharge control circuits.

3. The nonvolatile memory device of claim 2, wherein, when the plane selection circuit selects, as a verification and read operation target, each plane of the first group and the second group corresponding to the discharge control circuits of the first group and the second group, the operation control circuit sets the discharge control signal of the first group to the first voltage level and sets the discharge control signal of the second group to the second voltage level.

4. The nonvolatile memory device of claim 3, wherein, when the plane selection circuit selects the plane of the first group to be in an idle state and selects the plane of the second group as the verification and read operation target, the operation control circuit sets the discharge control signal of the first group to a disable level and sets the discharge control signal of the second group to a third voltage level that exceeds the first voltage level and is less than the second voltage level.

5. The nonvolatile memory device of claim 4, wherein, when the plane selection circuit selects the plane of the first group as the verification and read operation target and selects the plane of the second group to be in an idle state, the operation control circuit sets the discharge control signal of the first group to the first voltage level and sets the discharge control signal of the second group to the disable level.

6. The nonvolatile memory device of claim 3, wherein, when the plane selection circuit selects one of the planes of the first group and the second group as a program pulse application operation target and selects the remaining plane as the verification and read operation target, the operation control circuit sets each of the discharge control signals of the first group and the second group to the first voltage level.

7. The nonvolatile memory device of claim 4, further comprising:
a first voltage generation circuit configured to generate a first internal voltage having the first voltage level in a program pulse application operation duration and a verification and read operation duration; and
a second voltage generation circuit configured to generate a second internal voltage having a voltage level greater than or equal to the second voltage level in a program pulse application operation duration and to generate the second internal voltage having the third voltage level or the second voltage level in the verification and read operation duration.

8. The nonvolatile memory device of claim 7,
wherein the discharge control circuit of the first group comprises:
a first discharge transistor configured to control a connection between a common source line of the plane of the first group connected to a drain terminal thereof and the ground voltage terminal connected to a source terminal thereof, in response to the discharge control signal of the first group applied to a gate terminal thereof;
a first level setting unit configured to set the discharge control signal of the first group to a level of the first internal voltage in response to the plane of the first group being selected as the verification and read operation target or a program pulse application operation target by the plane selection circuit; and
a first idle setting unit configured to set the discharge control signal of the first group to the disable level in response to the plane of the first group being selected to be in the idle state by the plane selection circuit, and
wherein the discharge control circuit of the second group comprises:
a second discharge transistor configured to control a connection between a common source line of the plane of the second group connected to a drain terminal thereof and the ground voltage terminal connected to a source terminal thereof, in response to the discharge control signal of the second group applied to a gate terminal thereof;
a second level setting unit configured to set the discharge control signal of the second group to a level of the second internal voltage in response to the plane of the second group being selected as the verification and read operation target by the plane selection circuit;
a third level setting unit configured to set the discharge control signal of the second group to the level of the first internal voltage in response to the plane of the second group being selected as a program pulse application operation target by the plane selection circuit; and
a second idle setting unit configured to set the discharge control signal of the second group to the disable level in response to the plane of the second group being selected to be in the idle state by the plane selection circuit,
wherein the second discharge transistor is a high-voltage transistor having a thicker oxide film thickness than that of the first discharge transistor.

9. An operating method of a nonvolatile memory device comprising N planes each comprising a plurality of nonvolatile memory cells and N discharge control circuits for connecting each common source line of the N planes and a ground voltage terminal in response to each one of N discharge control signals, the operating method comprising:
selecting K planes of the N planes; and
adjusting voltage levels of K discharge control signals according to a distance difference between the ground voltage terminal and each one of K discharge control circuits corresponding to the K planes, wherein N is a natural number greater than or equal to 2, and K is a natural number less than or equal to N and greater than or equal to 1.

10. The operating method of claim 9, further comprising:
generating a first internal voltage having a first voltage level in a program pulse application operation duration and a verification and read operation duration; and
generating a second internal voltage having a voltage level greater than or equal to a second voltage level, which is greater than the first voltage level, in a program pulse application operation duration and generating the second internal voltage having the second voltage level or a third voltage level in the verification and read operation duration,
wherein in the adjusting voltage levels, the first internal voltage is received for a discharge control signal of a first group applied to a discharge control circuit of the first group adjacent to the ground voltage terminal among the N discharge control circuits and is set to the first voltage level, while the first internal voltage is received for a discharge control signal of a second group corresponding to a discharge control circuit of the second group further away from the ground voltage terminal than the discharge control circuit of the first group among the N discharge control circuits and is set to the first voltage level, or the second internal voltage is received and is set to the second voltage level or the third voltage level, and
the third voltage level is greater than the first voltage level and is less than the second voltage level.

11. The operating method of claim 10, wherein in the adjusting voltage levels, when each plane of the first group and the second group corresponding to the discharge control circuits of the first group and the second group is selected as a verification and read operation target in the selecting K planes, the first internal voltage is received for the discharge control signal of the first group and is set to the first voltage level, and the second internal voltage is received for the discharge control signal of the second group and is set to the second voltage level.

12. The operating method of claim 11, wherein in the adjusting voltage levels, when the plane of the first group is selected to be in an idle state and the plane of the second group is selected as the verification and read operation target in the selecting K planes, the discharge control signal of the first group is set to a disable level, and the second internal voltage is received for the discharge control signal of the second group and is set to the third voltage level.

13. The operating method of claim 12, wherein in the adjusting voltage levels, when the plane of the first group is selected as the verification and read operation target and the plane of the second group is selected to be in an idle state in the selecting K planes, the first internal voltage is received for the discharge control signal of the first group and is set to the first voltage level, and the discharge control signal of the second group is set to the disable level.

14. The operating method of claim 11, wherein in the adjusting voltage levels, when one of the planes of the first group and the second group is selected as a program pulse application operation target and the remaining plane is selected as the verification and read operation target in the selecting K planes, the first internal voltage is received for each of the discharge control signals of the first group and the second group and is set to the first voltage level.

15. A memory device comprising:
a plurality of planes, each plane including a plurality of memory cells coupled to a common source line;
a plurality of discharge control circuits coupled to the plurality of planes, respectively; and
a control circuit coupled to the plurality of planes, and including;
a plane selection circuit configured to generate selection signals for selecting multiple planes for a verification and read operation, among the plurality of planes; and
an operation control circuit configured to generate multiple discharge control signals to be provided to the multiple planes, based on a distance between a ground voltage terminal and each of multiple discharge control circuits corresponding to the multiple planes, among the plurality of discharge control circuits,
wherein the multiple planes connect the common source lines and the ground voltage terminal based on voltage levels of the multiple discharge control signals, respectively.
